# EUROPEAN PATENT SPECIFICATION

(11) **EP 3 196 949 B1**
(45) Date of publication and mention of the grant of the patent: **31.03.2021**
(21) Application number: 15826449.9
(22) Date of filing: 01.07.2015
(51) Int. Cl.: H01L 33/48, H01L 33/62, H05K 1/11, H05K 3/34

(54) **LED PACKAGE MOUNTING BOARD MOUNTED WITH A SURFACE MOUNT LED PACKAGE**
LED-MONTAGESUBSTRAT MIT OBERFLÄCHENMONTIERTEM LED-GEHÄUSE
SUBSTRAT DE MONTAGE DE BOÎTIER DE DEL MONTÉ AVEC UN BOÎTIER DE DEL DE TYPE MONTAGE EN SURFACE

(30) Priority: 31.07.2014 JP 2014155817
(43) Date of publication of application: 26.07.2017
(73) Proprietor: CCS Inc., Kyoto-shi, Kyoto 602-8011 (JP)
(72) Inventor: YAGI, Motonao, Kyoto-shi Kyoto 602-8011 (JP)
(74) Representative: Müller Hoffmann & Partner
(86) International application number: PCT/JP2015/068945
(87) International publication number: WO 2016/017352

(56) References cited:
- EP-A1- 1 528 602
- EP-A1- 2 455 966
- EP-A1- 2 485 284
- JP-A- 2005 286 099
- JP-A- 2006 186 000
- JP-A- 2009 141 006
- JP-A- 2010 021 426
- JP-A- 2012 227 446
- JP-A- 2013 140 938
- JP-A- 2013 153 004
- US-A1- 2008 316 724
- US-A1- 2012 002 420

## Description

### Technical Field

The present invention relates to an LED package mounting board mounted with a surface mount LED package.

### Background Art

Surface mount electronic parts are mounted on a board by being placed on pads preliminarily applied with cream solder or the like and, for example, being reflow-soldered. Meanwhile, a pad and a terminal joint surface of an electronic part are generally slightly different in size (in specifications, it is recommended to design a pad to be larger than a terminal joint surface of an electronic part), and as a result, when solder is melted in a reflow process, sometimes the electronic part moves on the pad to cause unexpected mispositioning. Of course it is also considered that when making the shape of the pad coincident with the shape of the terminal joint surface of the electronic part with accuracy, such mispositioning does not occur; however, in practice, since there is a variation in terminal shape among the respective electronic parts, it is impossible to make the shapes of the pads coincident with corresponding ones of the terminal joint surfaces of all the electronic parts, and therefore after all, the mispositioning cannot be eliminated.

In order to solve this problem, for example, in Patent Literature 1, it is adapted to prevent the mispositioning of an electronic part using the surface tension of solder by implementing a configuration adapted to purposely make the shape of a pad (a metallized layer) different from the shape of a terminal and overlap only part of the pad and part of the terminal joint surface of the electronic part with each other.

However, for example, when the electronic part is an LED, such a mispositioning preventing mechanism offers the advantage of being able to accurately arrange optical axes, but may cause a problem in heat dissipation. That is, in the case of an LED from which heat dissipation is regarded as particularly important, the structure adapted to only partly overlap a pad and a terminal joint surface as described above may cause the problem of being unable to sufficiently fulfill a heat dissipation function of the pad.

### Citation List

### Patent Literature

Patent Literature 1: JP-A2010-56399
Patent Literature 2: US 2012/0002420 A1
Patent Literature 3: JP-A 2009-141006
Patent Literature 4: JP-A 2012-227446

### Technical Problem

The present invention intends to easily prevent the mispositioning of a surface mount LED package at the time of soldering without impairing a heat dissipation function.

### Summary of Invention

The present invention provides an LED package mounting board mounted with a surface mounted LED package according to claim 1.

In such a configuration, when the LED is placed on the board in a state of, for example, deviating from the proper position to some extent, and solder is melted in a reflow process, on the boundaries of the part where the pad and the terminal are overlapping, i.e., on the boundaries of parts where the multiple pads and the multiple terminals corresponding one-to-one to the pads are overlapping, forces acts due to the surface tension of the molten solder, and the resultant force of these forces moves the LED. As a result, in the proper position where the LED is mounted, the non-overlapping part where the terminal corresponding to the differently-shaped pad and the differently-shaped pad do not overlap balances the resultant force, and therefore the movement of the LED stops in the proper position. For this reason, the LED can be surely arranged in the proper position through a soldering process, and mispositioning can be prevented.

Also, since the pad other than the heat dissipation pad is provided in an differently-shaped manner, an non-overlapping part can be prevented from being formed between the heat dissipation pad and a terminal corresponding to the heat dissipation pad, and therefore heat dissipation can be prevented from being impaired.
Note that the "differently-shaped pad" in the present invention includes one of which the shape itself is different from the corresponding terminal and also a similar one of which the shape is the same as that of the terminal but the size is different.

Also, as long as the substantially entire surface of a terminal joint surface corresponding to the heat dissipation pad is configured to be placed on the heat dissipation pad when mounting the LED in the proper position that is predetermined, the substantially entire surface of the joint surface of the heat dissipation terminal is overlapping with the heat dissipation pad in the proper position, and therefore a heat dissipation function that is important when mounting the LED can be ensured.

Meanwhile, as this sort of surface mount LED, there is one in which the side end surfaces of the package thereof are provided with bottomed grooves upward from the back surface. The bottomed grooves are configured such that parts of terminals pasted on the back surface of the package extend thereto, and solder is adapted to extend upward to the side circumference surfaces of the package along the parts of the extension. This structure allows so-called fillets to be formed to increase LED holding force, and also the bottomed grooves accommodate excessive solder to improve solderability.

When mounting such an LED, as long as the shape of the differently-shaped pad is set such that in the proper position, in the non-overlapping part between the differently-shaped pad and the joint surface of the terminal corresponding to the differently-shaped pad, the joint surface of the corresponding terminal protrudes from the differently-shaped pad toward a pad side adjacent to the differently-shaped pad, the part of the protrusion, i.e., a part where solder does not contact is provided in a location different from a bottomed groove or an extension part, and therefore good solderability can be kept without impairing the function of the bottomed groove or extension part.

As more specific embodiment, one applied to an LED including: an LED chip; a package mounted with the LED chip; and multiple rectangular-shaped terminals formed on the back surface of the package, in which the pads are ones that are provided side by side corresponding to the terminals and form substantially rectangular shapes, and among the pads, the differently-shaped pad is formed in a shape provided with a cutout in a corner part or a side on a pad side adjacent to the differently-shaped pad can be cited.

As a specific embodiment making it possible to keep good solderability, one applied to an LED that includes: an LED chip; a package mounted with the LED chip; and multiple rectangular-shaped terminals formed on the back surface of the package and in which parts of the terminals are adapted to form extension parts extending to a side end surface of the package, in which the pads are ones that are provided side by side corresponding to the terminals and form substantially rectangular shapes, and among the pads, the differently-shaped pad is formed in a shape provided with a cutout in one corner part or one side, in which the cutout is provided so as to avoid the extension parts can be cited.

If an acute angle part is present in the pad, the molten solder easily accumulates in the acute angle part, and the solder may overflow from the acute angle part to cause a short circuit or the like; however, in order to avoid such a problem, it is desirable that the corner angles of the differently-shaped pad are all set to 90 degrees or more.

Even in the case where not the pad side but the terminal side is configured in an differently-shaped manner as described above, when the LED is placed on the board in a state of, for example, deviating from the proper position to some extent and solder is melted in a reflow process, since the differently-shaped terminal adapted to balance the resultant force only in the proper position is provided, the LED moves toward the normal position due to the surface tension of the molten solder, and in the normal position where the resultant force is balanced, the movement of the LED stops. For this reason, the LED can be surely arranged in the normal position and mispositioning can be prevented.

Also, since a terminal other than the terminal corresponding to the heat dissipation pad is provided in an differently-shaped manner, an non-overlapping part can be prevented from being formed between the heat dissipation pad and the terminal corresponding to the heat dissipation pad, and therefore heat dissipation can be prevented from being impaired.

### Advantageous Effects of Invention

According to the present invention, without impairing a heat dissipation function, the positioning of a surface mount LED at the time of soldering can be easily performed.

### Brief Description of Drawings

[Fig. 1]

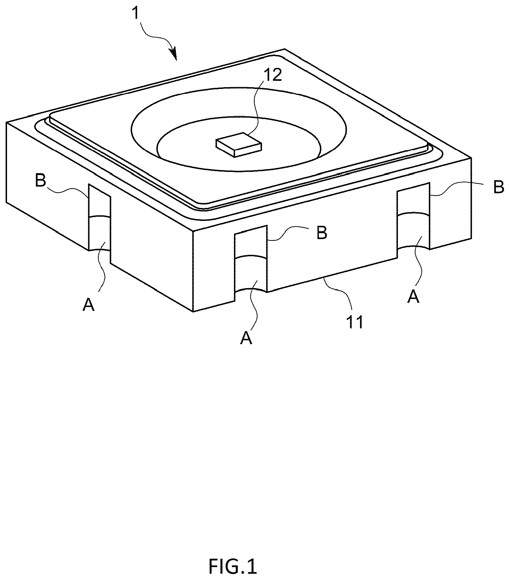

   Fig. 1 is a perspective view of an LED in one embodiment of the present invention as viewed from above.
[Fig. 2]

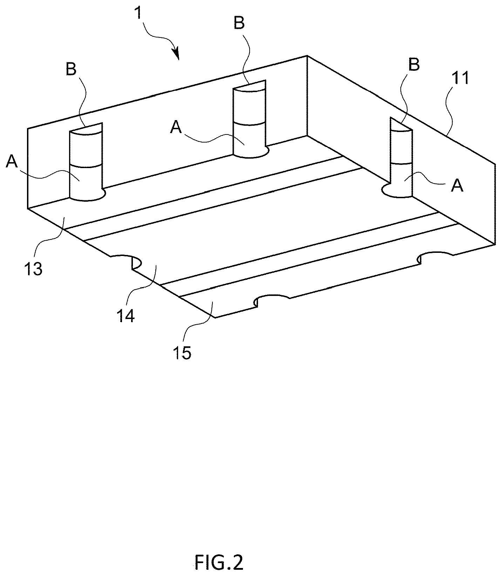

   Fig. 2 is a perspective view of the LED in the same embodiment as viewed from below.
[Fig. 3]

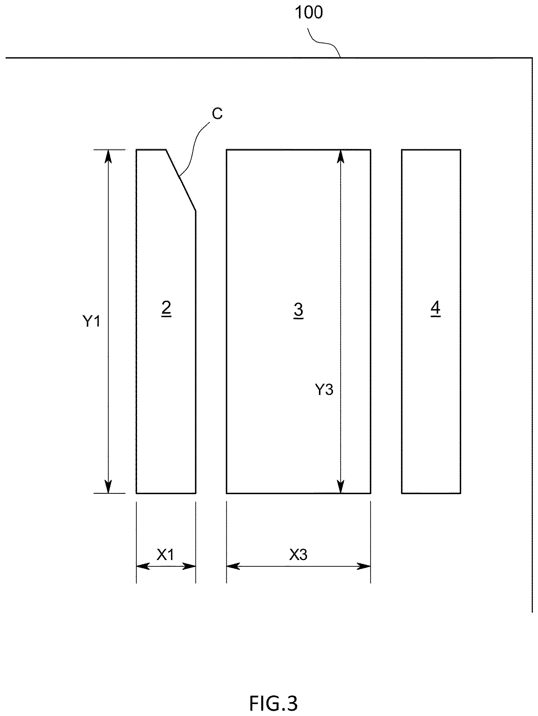

   Fig. 3 is a plan view illustrating pads of a board in the same embodiment.
[Fig. 4]

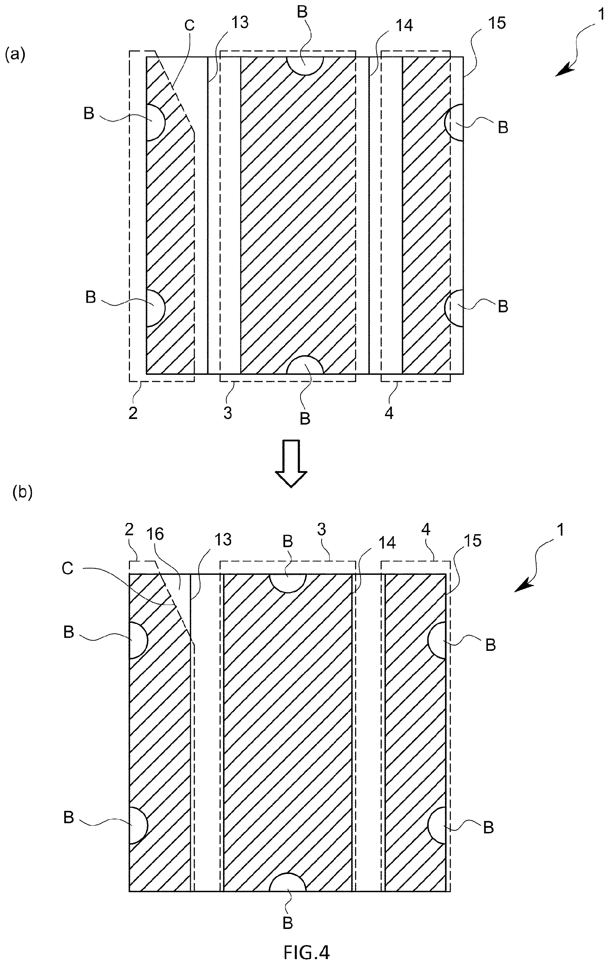

   Fig. 4 is an LED positioning process diagram illustrating a movement before the LED is positioned in the same embodiment.
[Fig. 5]

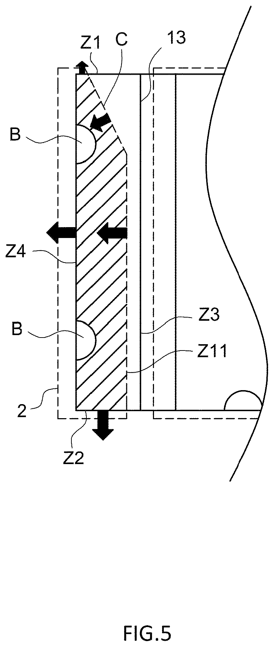

   Fig. 5 is an enlarged view in which a terminal and a pad in Fig. 4 are enlarged.
[Fig. 6]

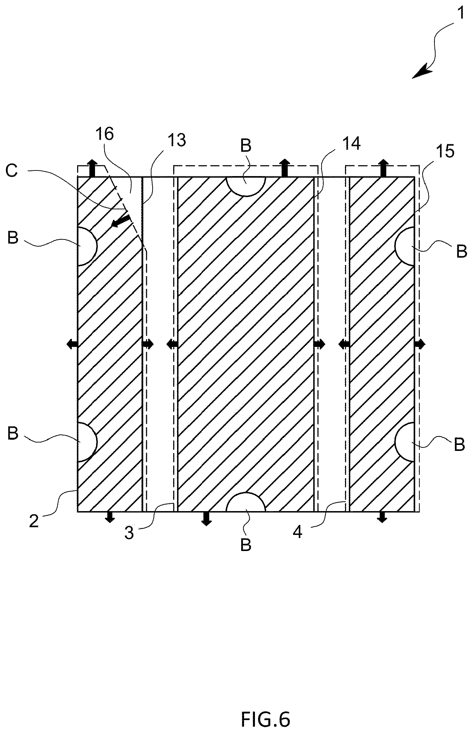

   Fig. 6 is a plan view illustrating force balance at the time of the positioning in Fig. 4.
[Fig. 7]

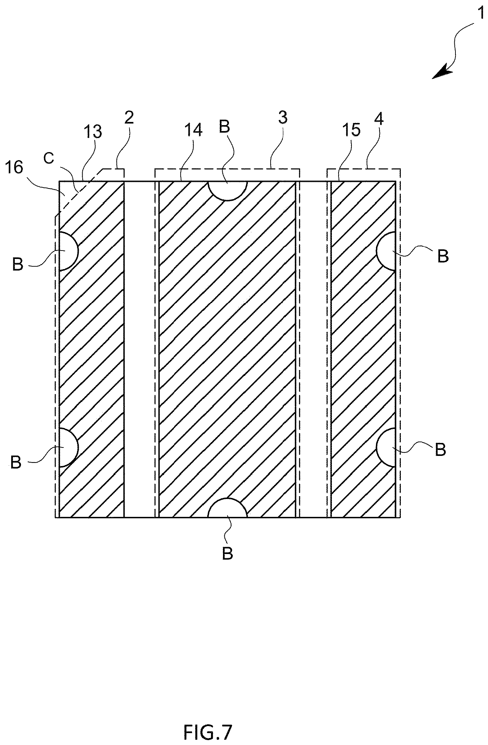

   Fig. 7 is a plan view illustrating pads in another embodiment of the present invention.
[Fig. 8]

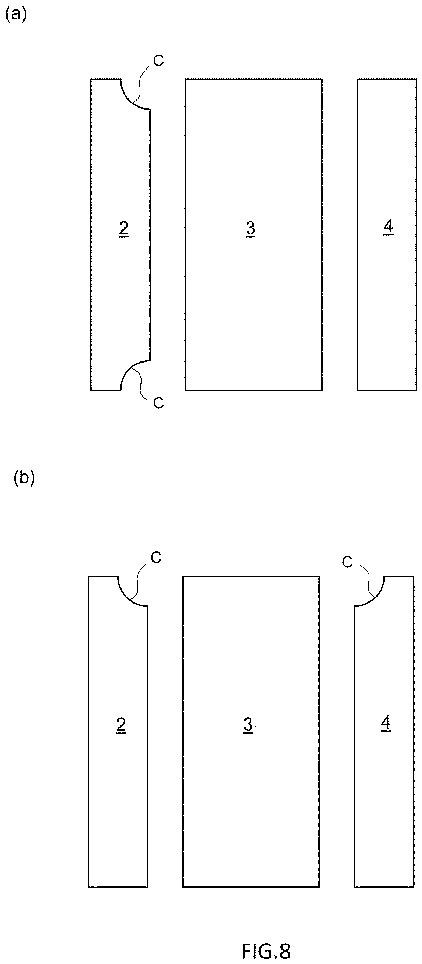

   Fig. 8 is a plan view illustrating pads in still another embodiment of the present invention.
[Fig. 9]

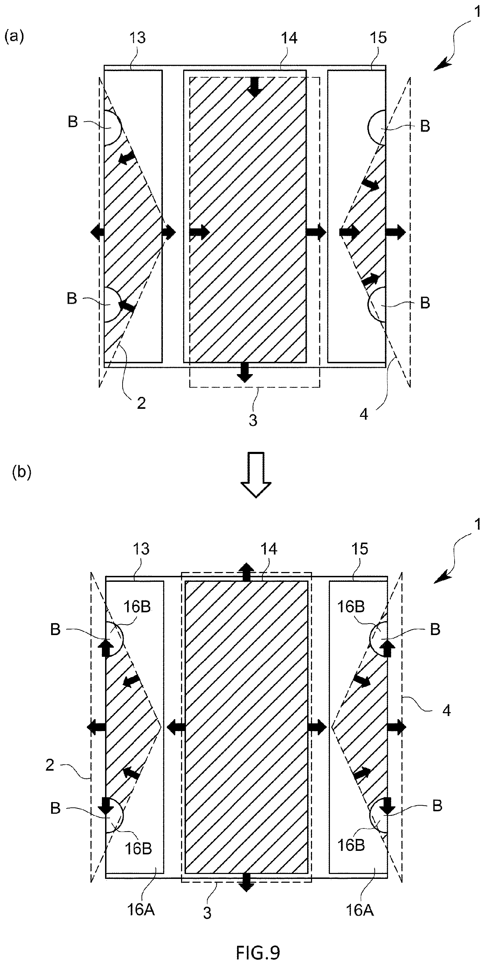

   Fig. 9 is an LED positioning process diagram illustrating a movement before an LED is positioned in yet another embodiment of the present invention.

### Reference Signs List

- 1: LED
- 2: Differently-shaped pad
- 3: Heat dissipation pad
- 4: Electrode pad
- 16: Non-overlapping part

### Description of Embodiments

An LED mounting board 100 (hereinafter also referred to as a "board 100") according to the present embodiment is a printed circuit board formed on the surface thereof with pads 2, 3, and 4 for soldering terminals 13, 14 and 15 of a surface mount LED 1 (hereinafter also referred to as an "LED 1").

Before describing the board 100, the outline of the LED 1 to be mounted on this board 100 will be described first.

As illustrated in Fig. 1 and Fig. 2, the LED 1 is a plate-like rectangular-shaped (here, square-shaped) one of a surface mount type, and includes: a plate-like square-shaped package 11; an LED chip 12 that is bonded to the center of a bottomed circular-shaped hole opening on the front surface side of the package 11; and the multiple (here, three) terminals 13, 14, and 15 formed on the back surface of the package 11 by gold plating.

The terminals 13, 14, and 15 are substantially rectangular-shaped ones that are provided side by side in a row at regular intervals and of which the lengthwise dimensions are the same and the crosswise dimensions are different. Note that hereinafter, an array direction of the terminals 13, 14, and 15 is referred to as a crosswise direction, and a direction orthogonal to the crosswise direction is referred to as a lengthwise direction.

Among these terminals 13, 14, and 15, the terminals 13 and 15 having narrow widths (crosswise dimensions) at both ends are respectively electrode (anode and cathode) terminals, and the terminal 14 having a wide width and the largest area at the center is a heat dissipation terminal. These respective terminals 13, 14, and 15 are extended not only on the back surface but also to the respective side end surfaces. The reason why extension parts A resulting from extending the terminals 13, 14, and 15 to the side end surfaces are provided is to increase holding force by making solder reach up to the side end surfaces of the package 11 through the extension parts A to form so-called fillets.

In this embodiment, in the respective side end surfaces of the package 11, bottomed grooves B extending from the back surface toward the front surface are provided, and on the bottom surfaces of the bottomed grooves B, the extension parts A that are gold plated are formed. The reason for providing the bottomed grooves B is partly to allow excessive solder to escape into the bottomed grooves B. Two of the bottomed grooves B are provided in each side end surface parallel to the lengthwise direction of the package 11, on which the extension parts A of the electrode terminal 13 or 15 are formed. Also, one of the bottomed grooves B is provided in each side surface parallel to the crosswise direction of the package 11, on which the extension part A of the heat dissipation terminal 14 is formed.

Meanwhile, on the board 100, as described above, the pads 2, 3, and 4 are provided in positions corresponding to the respective terminals 13, 14, and 15 of the LED 1 (see Fig. 3).

The pads 2 and 4 (hereinafter also referred to as electrode pads 2 and 4) corresponding to the electrode terminals 13 and 15 on both sides respectively form narrow width rectangular shapes, and are formed such that the crosswise dimensions X1 of them are substantially the same as or larger than the maximum allowable crosswise dimensions of the electrode terminals 13 and 15 and the lengthwise dimensions Y1 of them are substantially the same as or larger than the maximum allowable lengthwise dimensions of the electrode terminals 13 and 15.

Meanwhile, the pad 3 (hereinafter also referred to as the heat dissipation pad 3) corresponding to the heat dissipation terminal 14 in the center forms a wide width rectangular shape, and is formed such that both of the crosswise direction X3 and the lengthwise direction Y3 are the same as or larger than the maximum allowable dimensions of the heat dissipation terminal 14.

The LED 1 is soldered to the board 100 by applying, for example, cream solder to the electrode pads 2 and 4 and heat dissipation pad 3 adapted to be able to accommodate variations in dimensional errors of the terminals 13, 14, and 15 depending on the LED 1 as described above and placing the respective terminals 13, 14, and 15 of the LED 1 on them to perform reflow.

Also, in this embodiment, regarding one 2 of the electrode pads (hereinafter also referred to as an differently-shaped pad 2), the differently-shaped pad 2 is formed in a pentagonal shape by obliquely cutting one corner part of the two corner parts on the inner side thereof to form a cutout C.

Next, the behavior of the LED 1 at the time when placing the LED 1 on the board 100 configured as described above to perform reflow soldering will be described with reference to Fig. 4.

First, when the LED 1 is placed on the board 100, deviating from a predetermined proper position to some extent (see Fig. 4(a)), the melting of solder in a reflow process allows the surface tension of the molten solder to act so as to decrease the surface area of the molten solder, and therefore forces caused by the surface tension act on the boundaries of parts (parts indicated by hatched lines in the figure) where the terminals 13, 14, and 15 respectively overlap the differently-shaped pad 2, the heat dissipation pad 3, and the electrode pad 4. At this time, since the pads 2, 3, and 4 are fixed and do not move, the forces acting due to the surface tension act on the terminal 13, 14, 15 side.

As a result, as illustrated in Fig. 4(b), the resultant force of the forces moves the LED 1 in a direction of the corner part opposite to the cutout C (in the lower left direction of the paper surface), and the movement of the LED 1 stops in a position where the resultant force of the forces is balanced. The position where the resultant force is balanced is the proper position.

Here, while taking the terminal 13 as an example, the forces acting due to the surface tension will be described using Fig. 5. Fig. 5 is an enlarged view in which the differently-shaped pad 2 and the terminal 13 illustrated in Fig. 4 are enlarged. Note that for the purpose of description, as illustrated in Fig. 5, the side of the terminal 13 corresponding to the crosswise side provided with the cutout C of the differently-shaped pad 2 is denoted by Z1, the crosswise side opposite to the side Z1 by Z2, the side of the terminal 13 corresponding to the lengthwise side provided with the cutout C of the pad 2 by Z3, the lengthwise side opposite to the side Z3 by Z4, and the part of the terminal 13 overlapping the lengthwise side provided with the cutout C of the differently-shaped pad 2 by Z11.

As illustrated in Fig. 5, when the differently-shaped pad 2 and the terminal 13 are placed on each other in a position deviating from the proper position, on the sides Z1, Z2, Z4, and part Z11 of the terminal 13 positioned at boundaries of the part where the differently-shaped pad 2 and the terminal 13 are overlapping, forces respectively act due to the surface tension of the molten solder. On the side Z1, a lengthwise force from the size Z2 toward the size Z1 acts; on the side Z2, a lengthwise force from the side Z1 toward the side Z2 acts; and on the side Z4 and a part corresponding to the part Z11, crosswise forces from the side Z3 toward the side Z4 act.

The above-described forces all act in directions perpendicular to the sides at the boundaries of the part where the differently-shaped pad 2 and the terminal 13 are overlapping as well as being proportional to the lengths of the sides, respectively and correspondingly.

Note that although not illustrated, similar forces act due to the surface tension of the molten solder also between the heat dissipation pad 3 and the terminal 14 and between the electrode pad 4 and the terminal 15.

Also on a part where the terminal 13 and an oblique side forming the cutout C of the differently-shaped pad 2 overlap each other as well, a force caused by the surface tension of the molten solder acts, and the force is in a direction perpendicular to the side forming the cutout C.

As a result, as illustrated in Fig. 6, the LED 1 moves toward a position where the above-described forces are balanced, i.e., toward the proper position. In the proper position, a part forming the cutout C forms an non-overlapping part 16 where the terminal 13 and the differently-shaped pad 2 do not overlap, and the terminal 13 comes into a state of protruding from the differently-shaped pad 2.

Also, the non-overlapping part is provided such that the resulting force of the forces acting due to the surface tension of the molten solder is balanced only in the proper position, and consequently, the LED 1 is positioned in the proper position. The proper position in the present embodiment refers to a position where the sides Z2 and Z4 of the terminal 13 and corresponding sides of the differently-shaped pad 2 exactly overlap each other or slightly protrude from each other. Note that in this position, the surface tension is weakened, and therefore the forces correspondingly acting on the sides are also weakened.

As described, a mechanism adapted to provide the non-overlapping part 16 that is provided such that in the proper position, the terminal 13 and the differently-shaped pad 2 do not overlap, and the resultant force of the forces acting due to the surface tension of the molten solder is balanced makes it possible to move the LED 1 to the proper position to position the LED 1, and also since the resultant force is balanced in the proper position, prevent the mispositioning of the LED 1.

Also, since the cutout C for the mispositioning prevention or the positioning is provided only in the electrode pad 2 but not provided in the heat dissipation pad 3, the heat dissipation pad 3 contacts substantially the entire surface of a joint surface of the heat dissipation terminal 14 via the solder, and therefore heat dissipation performance can be reliably ensured.

Further, since the cutout C is provided in the inner corner part of the differently-shaped pad 2, i.e., provided on the adjacent heat dissipation pad 3 side, without interference with any bottomed groove B, neither the formation of a fillet in the extension part A provided on the bottomed groove B nor an excessive solder sucking function is impeded.

In addition, if an acute angle part is present in the differently-shaped pad 2, a solder reservoir is easily formed in the acute angle part, and the molten solder overflows from the solder reservoir to reach, for example, the adjacent heat dissipation pad 3, which may cause a short circuit; however, the corner angles of the differently-shaped pad 2 are all set to 90 degrees or more to eliminate the presence of an acute angle part, and therefore a problem due to solder overflow, such as a short circuit, can also be prevented.

Note that the present invention is not limited to the above-described embodiment.

For example, as illustrated in Fig. 7, the cutout C may be provided in an outer corner part of the electrode pad 2. In this case, it is preferable that the cutout C is adapted to be prevented from reaching an extension part A of a bottomed groove B. The shape of the cutout C is not limited to the triangular shape, but may be a partial arc shape, a partial elliptical shape, or besides, an indefinite shape defined by multiple curves and straight lines.

Also, in the above-described embodiment, the positioning is performed so as to align the corner of the differently-shaped pad 2 with the corner of the terminal 13; however, it may be configured to perform the positioning so as to align the centerlines of the pad 2 and the terminal 13 with each other. For example, as illustrated in Fig. 8(a), when providing cutouts C in both of the inner corner parts of the pad 2 symmetrically, and making the shape of the cutouts C partially circular, the positioning can be performed with the lengthwise centerline as a reference.

Further, the number of differently-shaped pad is not limited to one, but may be two. For example, as illustrated in Fig. 8(b), cutouts C may be respectively symmetrically provided in the electrode pads 2 and 4 to configure them as differently-shaped pads. In doing so, the positioning can be performed with the crosswise centerline as a reference.

Still further, as another configuration adapted to provide multiple differently-shaped pads, for example, as illustrated in Fig. 9, one adapted to configure the pads 2 and 4 arranged at the both ends of the heat dissipation pad 3 as differently-shaped pads can be cited.

In this embodiment, the differently-shaped pads 2 and 4 respectively form substantially triangular shapes that are arranged so as to be symmetrical with respect to the heat dissipation pad 3, and specifically, the differently-shaped pads are ones forming an obtuse isosceles triangle in which the interior angle of one of the three vertices is an obtuse angle equal to or more than 90 degrees and two sides sandwiching the vertex forming the obtuse angle have the same length. The obtuse angle vertices of the differently-shaped pads 2 and 4 both face in directions in which the heat dissipation pad 3 is arranged.

By configuring as described above, as illustrated in Fig. 9(a), on the boundaries of parts where the differently-shaped pads 2 and 4 and heat dissipation pad 3 are respectively overlapping with the terminals 13, 14, and 15, forces act due to the surface tension of the molten solder, and the resultant force of the forces moves the LED 1 in the lower right direction of the paper surface.

As a result, as illustrated in Fig. 9(b), in a proper position where the resultant force is balanced, non-overlapping parts 16A where the differently-shaped pads 2 and 4 do not respectively overlap the terminals 13 and 15 fix the LED 1 from moving in the crosswise direction and also semicircular-shaped bottomed groove B parts (non-overlapping parts 16B) fix the LED 1 from moving in the lengthwise direction, and therefore positioning can be performed with the lengthwise centerline and crosswise centerline of the LED 1 as a reference.

Further, the present invention can also be applied to a two-terminal LED having only electrode terminals. In the case of such an LED, a joint surface of any of the terminals is set to be larger, and that terminal mainly carries a heat dissipation function, and therefore it is preferable to provide a cutout in the terminal having a low heat dissipation function, i.e., in the terminal having a smaller joint surface.

Also, when giving a top priority to providing the cutout in a position avoiding an extension part, it is also possible to provide the cutout in the heat dissipation pad.

An differently-shaped pad may have a shape that is cannot be generally referred to as a shape provided with a so-called cutout, and in short, is only required to be configured so as to provide an non-overlapping part where a terminal and the pad do not overlap in a proper position and fix an LED in the proper positon. This makes it possible to uniquely determine the position of the LED when solder is melted and prevent unexpected mispositioning.

Also, the above-described embodiments are ones adapted to provide the pad side in an differently-shaped manner, but may be ones adapted to provide the terminal side in the differently-shaped manner.

In this case, a surface mount LED that is to be mounted on a surface mounting board having multiple pads and has multiple terminals to be respectively soldered to the pads, in which at least one terminal (hereinafter referred to as an "differently-shaped terminal) other than a terminal corresponding to a pad having the highest heat dissipation function (hereinafter referred to as a "heat dissipation pad") forms a shape different from the shape of a pad corresponding to the one terminal can be cited.

Besides, needless to say, the present invention is not limited to the above-described embodiments, but can be variously modified without departing from the scope of the present invention as defined by the claims.

### [Industrial Applicability]

The main object of the present invention is to provide an LED mounting board capable of, without impairing a heat dissipation function, easily preventing the mispositioning of a surface mount LED package at the time of soldering.

## Claims

1. An LED package mounting board (100) mounted with a surface mount LED package (1) having multiple terminals (13, 14, 15),
the LED package mounting board (100) comprising multiple pads (2, 3, 4) to which the terminals (13, 14, 15) are respectively soldered, wherein at least one pad (2), other than a heat dissipation pad (3) having a highest heat dissipation function with respect to the LED package (1) among the multiple pads (2, 3, 4), forms a shape different from a shape of a terminal (13) corresponding to the differently-shaped pad (2),
wherein, in a proper position where the LED package (1) is mounted, the terminal (13) corresponding to the differently-shaped pad (2) and the differently-shaped pad (2) have a non-overlapping part (16, 16A, 16B), and a joint surface of the terminal (13) corresponding to the differently-shaped pad (2) protrudes from the differently-shaped pad (2), and
wherein
the non-overlapping part (16, 16A, 16B) is provided such that only in the proper position where the LED package (1) is mounted, a resultant force of forces acting on boundaries of a part where the differently-shaped pad (2) and the terminal (13) corresponding to the differently-shaped pad (2) are overlapped is balanced due to surface tension of molten solder.

2. The LED package mounting board (100) according to claim 1, wherein in the proper position where the LED package (1) is mounted, a substantially entire surface of a terminal joint surface corresponding to the heat dissipation pad (3) is placed on the heat dissipation pad (3).

3. The LED package mounting board (100) according to claim 1,
wherein the shape of the differently-shaped pad (2) is set such that in the proper position, in the non-overlapping part (16) between the differently-shaped pad (2) and a joint surface of the termina (13) corresponding to the differently-shaped pad (2), the joint surface of the corresponding terminal (13) protrudes from the differently-shaped pad (2) toward a pad side (3) adjacent to the differently-shaped pad (2).

4. The LED package mounting board (100) according to claim 1,
wherein the LED package (1) comprises: an LED (12); a package (11) mounted with the LED chip (12); and multiple rectangular-shaped terminals (13, 14, 15) formed on a back surface of the package (11), wherein
the pads (2, 3, 4) are ones that are provided side by side corresponding to the terminals (13, 14, 15) and form substantially rectangular shapes, and among the pads (2, 3, 4), the differently-shaped pad (2) is formed in a shape provided with a cutout (C) in a corner part or a side on a pad side (3) adjacent to the differently-shaped pad (2).

5. The LED package mounting board (100) according to claim 1,
wherein the LED package (1) comprises: an LED chip (12); a package (11) mounted with the LED chip (12); and multiple rectangular-shaped terminals (13, 14, 15) formed on a back surface of the package (11) and in which parts of the terminals (13, 14, 15) are adapted to form extension parts (A) extending to a side end surface of the package (11), wherein
the pads (2, 3, 4) are ones that are provided side by side corresponding to the terminals (13, 14, 15) and form substantially rectangular shapes, and among the pads (2, 3, 4), the differently-shaped pad (2) is formed in a shape provided with a cutout (C) in one corner part or one side, wherein the cutout (C) is provided so as to avoid the extension parts (A).

6. The LED package mounting board (100) according to claim 1,
wherein corner angles of the differently-shaped pad (2) are all set to 90 degrees or more.

## Patentansprüche

1. Platine (100) zur LED-Gehäusemontage mit einem oberflächenmontierten LED-Gehäuse (1), das mehrere Anschlüsse (13, 14, 15) aufweist,
wobei die Platine (100) zur LED-Gehäusemontage mehrere Pads (2, 3, 4) aufweist, an die die Anschlüsse (13, 14, 15) jeweils gelötet sind, wobei zumindest ein Pad (2), mit Ausnahme eines Wärmeableitungs-Pads (3), das eine höchste Wärmeableitungsfunktion bezüglich des LED-Gehäuses (1) unter den mehreren Pads (2, 3, 4) aufweist, eine Form bildet, die sich von einer Form eines Anschlusses (13) unterscheidet, der dem unterschiedlich geformten Pad (2) entspricht,
wobei in einer richtigen Position, in der das LED-Gehäuse (1) montiert ist, der dem unterschiedlich geformten Pad (2) entsprechende Anschluss (13) und das unterschiedlich geformte Pad (2) einen nicht überlappenden Teil (16, 16A, 16B) aufweisen und eine Verbindungsfläche des dem unterschiedlich geformten Pad (2) entsprechenden Anschlusses (13) von dem unterschiedlich geformten Pad (2) vorragt und
wobei der nicht überlappende Teil (16, 16A, 16B) so vorgesehen ist, dass nur in der richtigen Position, in der das LED-Gehäuse (1) montiert ist, eine resultierende Kraft von Kräften, die auf Ränder eines Teils wirken, wo das unterschiedlich geformte Pad (2) und der dem unterschiedlich geformten Pad (2) entsprechende Anschluss (13) überlappen, aufgrund der Oberflächenspannung von geschmolzenem Lot ausgeglichen sind.

2. Platine (100) zur LED-Gehäusemontage nach Anspruch 1,
wobei in der richtigen Position, in der das LED-Gehäuse (1) montiert ist, eine im Wesentlichen gesamte Oberfläche einer Verbindungsfläche eines Anschlusses, die dem Wärmeableitungs-Pad (3) entspricht, auf dem Wärmeableitungs-Pad (3) platziert ist.

3. Platine (100) zur LED-Gehäusemontage nach Anspruch 1,
wobei die Form des unterschiedlich geformten Pads (2) so festgelegt ist, dass in der richtigen Position im nicht überlappenden Teil (16) zwischen dem unterschiedlich geformten Pad (2) und einer Verbindungsfläche des dem unterschiedlich geformten Pad (2) entsprechenden Anschlusses (13) die Verbindungsfläche des entsprechenden Anschlusses (13) vom unterschiedlich geformten Pad (2) in Richtung einer Pad-Seite (3) vorragt, die dem unterschiedlich geformten Pad (2) benachbart ist.

4. Platine (100) zur LED-Gehäusemontage nach Anspruch 1,
wobei das LED-Gehäuse (1) aufweist:
einen LED-Chip (12);
ein Gehäuse (11), das mit dem LED-Chip (12) bestückt ist;
und mehrere rechteckig geformte Anschlüsse (13, 14, 15), die auf einer rückseitigen Oberfläche des Gehäuses (11) ausgebildet sind, wobei
die Pads (2, 3, 4) welche sind, die entsprechend den Anschlüssen (13, 14, 15) nebeneinander vorgesehen sind und im Wesentlichen rechteckige Formen bilden, und unter den Pads (2, 3, 4) das unterschiedlich geformte Pad (2) in einer Form ausgebildet ist, die mit einem Ausschnitt (C) in einem Eckteil oder einer Seite auf einer Pad-Seite (3), die dem unterschiedlich geformten Pad (2) benachbart ist, versehen ist.

5. Platine (100) zur LED-Gehäusemontage nach Anspruch 1,
wobei das LED-Gehäuse (1) aufweist:
einen LED-Chip (12);
ein Gehäuse (11), das mit dem LED-Chip (12) bestückt ist;
und mehrere rechteckig geformte Anschlüsse (13, 14, 15), die auf einer rückseitigen Oberfläche des Gehäuses (11) ausgebildet sind, und worin Teile der Anschlüsse (13, 14, 15) dafür angepasst sind, Verlängerungsteile (A) zu bilden, die sich zu einer seitlichen Endfläche des Gehäuses (11) erstrecken,
wobei die Pads (2, 3, 4) welche sind, die entsprechend den Anschlüssen (13, 14, 15) nebeneinander vorgesehen sind und im Wesentlichen rechteckige Formen bilden, und unter den Pads (2, 3, 4) das unterschiedlich geformte Pad (2) in einer Form ausgebildet ist, die mit einem Ausschnitt (C) in einem Eckteil oder einer Sete versehen ist, wobei der Ausschnitt (C) so vorgesehen ist, dass er die Verlängerungsteile (A) meidet.

6. Platine (100) zur LED-Gehäusemontage nach Anspruch 1,
wobei die Eckwinkel des unterschiedlich geformten Pads (2) alle auf 90 Grad oder mehr festgelegt sind.

## Revendications

1. Carte de montage de boîtier de DEL (100) montée avec un boîtier de DEL (1) à montage de surface ayant de multiples bornes (13, 14, 15),
la carte de montage de boîtier de DEL (100) comprenant de multiples pastilles (2, 3, 4) auxquelles les bornes (13, 14, 15) sont respectivement brasées, dans lequel au moins une pastille (2), autre qu'une pastille de dissipation de chaleur (3) ayant une fonction de dissipation de chaleur maximale par rapport au boîtier de DEL (1) parmi les multiples pastilles (2, 3, 4), forme une forme différente d'une forme d'une borne (13) correspondant à la pastille (2) de forme différente,
dans lequel dans une bonne position où le boîtier de DEL (1) est monté, la borne (13) correspondant à la pastille (2) de forme différente et la pastille (2) de forme différente ont une partie sans chevauchement (16, 16A, 16B), et une surface de joint de la borne (13) correspondant à la pastille (2) de forme différente dépasse de la pastille (2) de forme différente, et
dans lequel la partie sans chevauchement (16, 16A, 16B) est prévue de telle sorte que seulement dans la bonne position où le boîtier de DEL (1) est monté, une force résultante de forces agissant sur des limites d'une partie où la pastille (2) de forme différente et la borne (13) correspondant à la pastille (2) de forme différente se chevauchent soit équilibrée en raison de la tension de surface de la brasure fondue.

2. Carte de montage de boîtier de DEL (100) selon la revendication 1,
dans laquelle dans la bonne position où le boîtier de DEL (1) est monté, une surface sensiblement entière d'une surface de joint de borne correspondant à la pastille de dissipation de chaleur (3) est placée sur la pastille de dissipation de chaleur (3).

3. Carte de montage de boîtier de DEL (100) selon la revendication 1,
dans laquelle la forme de la pastille (2) de forme différente est fixée de telle sorte que dans la bonne position, dans la partie sans chevauchement (16) entre la pastille (2) de forme différente et une surface de joint de la borne (13) correspondant à la pastille (2) de forme différente, la surface de joint du terminal (13) correspondant dépasse de la pastille (2) de forme différente vers un côté de pastille (3) adjacent à la pastille (2) de forme différente.

4. Carte de montage de boîtier de DEL (100) selon la revendication 1,
dans laquelle le boîtier de DEL (1) comprend une puce à DEL (12) ; un boîtier (11) monté avec la puce à DEL (12) et de multiples bornes (13, 14, 15) de forme rectangulaire formées sur une surface arrière du boîtier (11),
dans lequel les pastilles (2, 3, 4) sont des pastilles qui sont prévues côte à côte d'une manière correspondant aux bornes (13, 14, 15) et forment des formes sensiblement rectangulaires, et parmi les pastilles (2, 3, 4), la pastille (2) de forme différente est formée en une forme pourvue d'une découpe (C) dans une partie d'angle ou un côté sur un côté de pastille (3) adjacent à la pastille (2) de forme différente.

5. Carte de montage de boîtier de DEL (100) selon la revendication 1,
dans laquelle le boîtier de DEL (1) comprend : une puce à DEL (12) ; un boîtier (11) monté avec la puce à DEL (12), et de multiples bornes (13, 14, 15) de forme rectangulaire formées sur une surface arrière du boîtier (11) et dans lequel des parties des bornes (13, 14, 15) sont adaptées pour former des parties d'extension (A) s'étendant jusqu'à une surface d'extrémité latérale du boîtier (11),
dans lequel les pastilles (2, 3, 4) sont des pastilles qui sont prévues côte à côte d'une manière correspondant aux bornes (13, 14, 15) et forment des formes sensiblement rectangulaires, et parmi les pastilles (2, 3, 4), la pastille (2) de forme différente est formée en une forme pourvue d'une découpe (C) dans une seule partie d'angle ou un seul côté sur un seul côté, dans lequel la découpe (C) est prévue de manière à éviter les parties d'extension (A).

6. Carte de montage de boîtier de DEL (100) selon la revendication 1,
dans laquelle les parties d'angle de la pastille (2) de forme différente sont toutes fixées à 90 degrés ou plus.
